# EUROPEAN PATENT SPECIFICATION

(11) **EP 4 711 773 B1**
(45) Date of publication and mention of the grant of the patent: **02.12.2026**
(21) Application number: 24200493.5
(22) Date of filing: 16.09.2024
(51) Int. Cl.: G01R 15/06, G01R 15/16, G01R 19/32, G01R 19/155, H01B 17/28

(54) **SENSORED INSULATION PLUG WITH TEMPERATURE SENSOR**
SENSORISOLIERSTOPFEN MIT TEMPERATURSENSOR
FICHE ISOLANTE À CAPTEUR AVEC CAPTEUR DE TEMPÉRATURE

(43) Date of publication of application: 18.03.2026
(73) Proprietor: 3M Innovative Properties Company, Saint Paul, MN 55133-3427 (US)
(72) Inventor: Stollwerck, Gunther, 47802 Krefeld (DE); Bund, Christine Brigitte, 42111 Wuppertal (DE); Gunjaca, Mirco, 48301 Nottuln (DE); Milek, Martin Andreas, 46045 Oberhausen (DE); Reeken, Rainer, 41542 Dormagen (DE)
(74) Representative: Müller, Bruno

(56) References cited:
- EP-A1- 2 508 898
- EP-A1- 3 671 227
- EP-A1- 4 001 928
- EP-A1- 4 099 024
- CN-A- 116 209 906
- US-A1- 2018 210 013
- US-A1- 20240 295 592

## Description

This disclosure relates to insulation plugs for separable connectors in medium-voltage and high-voltage power distribution networks. In particular, it relates to such plugs that have a voltage detection feature and a temperature sensor and to installation methods therefor. The disclosure also relates to separable connectors having such plugs installed therein, and to power distribution networks comprising such separable connectors.

Power distribution networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as in switchgears or transformers to collect information about the current state of their power network.

In a medium-voltage or high-voltage power distribution network, a power cable is typically connected to network apparatus, such as switchgears or transformers, by a separable connector, also often referred to as a removable power connector, mounted at the end of the cable. Such separable connectors have a front cavity to receive a protruding portion of a bushing of the apparatus, and a connection element on high or medium voltage. The connection element is in electrical contact with the cable conductor and can be mechanically and electrically connected to the bushing, e.g. via a threaded stud accessible through an opposed rear cavity of the separable connector. After installation, the rear cavity is filled by inserting a so-called insulation plug, which insulates the connection element.

Elements of a voltage sensor for measuring the voltage of the connection element of a separable connector - and thereby the voltage of the power cable - can be integrated into the insulation plug, making it a "sensored insulation plug". A voltage sensor of that type is described, for example, in the U.S. patent US 6,031,368.

In order to sense the voltage of the connection element with high accuracy, a capacitive voltage divider (a "sensing voltage divider") may be used, of which the dividing ratio is precisely known. The high-voltage portion of such a sensing voltage divider is often a single capacitor, the "primary capacitor" or the "high-voltage capacitor". Advantageously the primary capacitor, or the entire high-voltage portion, is accommodated in the sensored insulation plug, making use of the insulative properties of the body of the insulation plug. The high-voltage capacitor of the sensing voltage divider is also referred herein as the "sensing capacitor" of the sensored insulation plug. The European patent application EP 4001928 A1 relates to a sensored insulation plug which comprises a plug body and a primary capacitor operable as a high-voltage capacitor in a voltage divider for sensing the elevated voltage, the primary capacitor having a high-voltage electrode for direct electrical connection to the elevated voltage, a sensing electrode of a tubular shape, embedded in the plug body, arranged around the high-voltage electrode, and a dielectric formed by a portion of the insulating material arranged between the sensing electrode and the high-voltage electrode.

The low-voltage portion of the sensing voltage divider comprises one or more low-voltage capacitors. These low-voltage capacitors may be comprised in the sensored insulation plug or may alternatively be located outside of the sensored insulation pug, close to, or even remote from the sensored insulation plug, such as in a remote terminal unit.

In such capacitive sensing voltage dividers, the set of dividing capacitors (i.e., at least the sensing capacitor and a low-voltage capacitor) is exposed to the elevated voltage of the power conductor and divides that elevated voltage, either in fewer and larger steps via a small number of capacitors having higher voltage ratings, or in more, smaller steps via a greater number of capacitors that can have lower voltage ratings. Discrete capacitors that have both a high voltage rating and a larger capacity are generally rare and expensive. For dividing down an elevated voltage of tens of kilovolt, a larger number of discrete capacitors of high voltage rating, connected in series, would be required. Besides the cost, the space required to accommodate them is often prohibitive. Instead of discrete capacitors, where a voltage sensor for elevated voltages requires a high voltage rating and a comparatively large capacity, an integrated capacitor can be used. An integrated capacitor is a capacitor that is formed by structural elements of the sensored insulation plug rather than by a separate, discrete electrical device.

Capacitors of the sensing voltage divider require adequate electrical insulation in order to reduce the risk of electrical discharges between any capacitor on a higher voltage and an element on lower voltage. Due to the strong electrical fields in the vicinity of the dividing capacitor(s) of the high-voltage portion of the voltage divider, the insulating material must be a good insulator and provide a high barrier to discharges. Any void or bubble in the insulating material may give rise to partial discharges.

Embedding capacitors of a medium-voltage/high-voltage (MV/HV) voltage divider in a plug body made of an insulating material, such as a solidified casting materials, is a way of obtaining a strong, mostly void-free electrical insulation, with the added benefit of mechanical rigidity of the plug body. When manufacturing such a plug body, a liquid, viscous, electrically insulating casting material flows around the electrodes of integrated capacitors in a mold, filling all available space and thus reducing the risk of formation of voids. The casting material is then caused to cure and thereby solidify. The solidified insulating material forms the body of the sensored insulation plug.

Variations of the temperature of the sensored insulation plug can result in variations of the capacitance of the sensing capacitor: the spacing between the high-voltage electrode and the sensing electrode may change due to thermal expansion or contraction of the electrode materials or of the dielectric, and the permittivity of the dielectric may change with changing temperature. The change in capacitance of the sensing capacitor generally translates into a corresponding change in the dividing ratio of the sensing voltage divider. Knowledge about the precise value of the dividing ratio, however, is required for a precise sensing of the elevated voltage, which is determined by multiplying the divided voltage (the "signal voltage") picked up from the sensing electrode with the dividing ratio. In order to obtain temperature correction factors and apply them to obtain more accurate voltage measurements it is thus desirable to determine the temperature of the plug body.

In an attempt to address this need the present disclosure provides a sensored insulation plug for being inserted into a rear cavity of a medium voltage or high-voltage separable connector in a power distribution network of a national grid, and operable to insulate a connection element of the separable connector on an elevated voltage and to sense the elevated voltage, the sensored insulation plug comprising
a) a plug body formed by a first electrically insulating material and rotationally symmetric about a plug axis defining axial directions and radial directions orthogonal to the axial directions;
b) an integrated sensing capacitor, operable as a high-voltage capacitor in a sensing voltage divider for sensing the elevated voltage, the sensing capacitor comprising i) a high-voltage electrode, electrically connected to the connection element when the sensored insulation plug is inserted into the rear cavity of the separable connector; ii) a sensing electrode, embedded in the first insulating material, iii) a dielectric arranged between the high-voltage electrode and the sensing electrode and comprising a portion of the first insulating material,
c) a circuit board comprising a signal contact, electrically conductively connected to the sensing electrode,
d) a temperature sensor, arranged on the circuit board and comprising a sensor probe, operable to sense a temperature in the vicinity of the sensor probe, in surface contact with, or thermally coupled to, the first insulating material, for sensing a temperature of the first insulating material.

In a sensored insulation plug according to the present disclosure the temperature sensor senses the temperature of the first insulating material. The temperature of the first insulating material can thus be taken into account when determining the dividing ratio of the sensing voltage divider at a specific point in time. This facilitates a more precise determination of the elevated voltage at that time. A calibration step in the factory where the sensored insulation plug is manufactured can generate, for example, a digital look-up table which specifies, for each temperature, the dividing ratio at that temperature or a correction factor for that temperature. A value from the look-up table can be applied to correct and adjust each measurement of the elevated voltage taken via the sensing voltage divider.

Separable connectors are often used to connect a medium-voltage (MV) or high-voltage (HV) power cable to a bushing of a switchgear or of a transformer. Should the electrical connection between the separable connector and the bushing be weak, ohmic losses will heat up the bushing and the connector, including the insulation plug in the connector. In a second aspect the temperature monitoring of the insulation plug may thus allow, potentially in conjunction with other temperature sensors, monitoring the health of the electrical connection between the connector and the bushing and facilitate issuing an automatic alert if a rise in the temperature of the sensored insulation plug indicates a faulty connection.

The temperature sensor is arranged on the same circuit board which comprises the signal contact connected to the sensing electrode. This arrangement saves space in the interior of the plug body. That space would otherwise be required for accommodating a second circuit board supporting the temperature sensor. In insulation plugs according to the present disclosure the corresponding space can be used to accommodate more insulating material, so that the electrical insulation of the insulation plug is improved and the risk of air gaps between a circuit board and the surrounding insulating material - and the associated risk of electrical discharges and deterioration of the insulation plug - is reduced.

The present disclosure relates to voltage sensing devices for use in medium-voltage or high-voltage power distribution networks which distribute electrical power over large geographic areas via HV/MV power cables, transformers, switchgears, substations etc. with currents of tens or hundreds of amperes and voltages of tens or hundreds of kilovolts. The term "medium voltage" or "MV" as used herein refers to AC voltages in the range of 1 kilovolt (kV) to 72 kV, whereas the term "high voltage" or "HV" refers to AC voltages of more than 72 kV. Medium voltage and high voltage are collectively referred to herein as "elevated voltage".

Many separable connectors are T-shaped or elbow-shaped. A separable connector as referred to herein usually has a front cavity to receive a protruding portion of a bushing of the switchgear or the transformer, and an opposed rear cavity facilitating access to a connection element, such as a cable lug, on elevated voltage inside the separable connector. The connection element is conductive and is electrically and mechanically connected to the power conductor of the power cable. The connection element can be connected mechanically and electrically, e.g. by a conductive threaded stud, to a conductive element of the bushing, so that power can flow from the power cable through the connection element, the stud and the bushing into the switchgear or transformer. When the separable connector is in use, the connection element is on the elevated voltage of the power conductor of the cable.

Certain separable connectors are described in the European patent application EP 0 691 721 A1. Examples of traditional separable connectors are the 3M^{™} 600 Amp T-Bodies 5815 Series from 3M Co., St. Paul, Minnesota, U.S.A., or the "(M) (P) 480 TB separable tee shape connector" of Nexans Network Solutions N.V., Erembodegem, Belgium.

The rear cavity of a separable connector can receive a matching insulation plug to insulate the connection element and to fill the space of the rear cavity to reduce the risk of electrical discharges. Such matching pairs of separable connector and insulation plug are commercially available at moderate cost. In many cases, the mechanical interface between a separable connector and an insulation plug is governed by de-facto standards. Many of such interfaces conform to an existing standard for bushings, some form a Type C interface as described in the German standards DIN EN 50180 for bushings and DIN EN 50181 for plug-in type bushings, others conform to ANSI/IEEE standard 386. Often, bodies of insulation plugs are slightly larger than the rear cavity, so that after the plug is urged into the rear cavity with some force, the surfaces of plug and cavity are in an intimate surface contact, thus reducing the risk of electrical discharges.

The sensored insulation plug according to the present disclosure is shaped for being inserted into, and mating with a rear cavity of a separable connector - in the same way as the body of a conventional, non-sensored insulation plug. The plug body may be rotationally symmetric about a plug axis. The body of the sensored insulation plug may, for example, have a frustoconical shape for being inserted into a corresponding frustoconical recess of corresponding shape (the rear cavity) at a rear side of the separable connector, thereby mating the sensored insulation plug with the separable connector.

A connection element of a separable connector is electrically connected to the conductor of the power cable terminated by the separable connector and is on elevated voltage when the cable is in use.

Some separable connectors comprise a connection element such as a cable lug, attached to the end of the central conductor of the power cable and protruding into a space between the front cavity and the rear cavity. The protruding portion of the connection element usually has an aperture or a thread for attachment to a stud or screw which connects the connection element electrically and mechanically, e.g. with a conductor of a bushing.

The connection element of the separable connector serves to electrically and mechanically connect the power cable and the separable connector to a bushing. The high-voltage electrode of the sensing capacitor of the sensored insulation plug as described herein is - when in use - directly electrically connected to the connection element, so that a voltage sensor based on a voltage divider comprising the sensing capacitor in its high-voltage portion, or a voltage detector based on a voltage divider comprising the testpoint capacitor in its high-voltage portion, can sense or detect the elevated voltage of the connection element and thereby the elevated voltage of the power cable conductor, after connection of the power cable to the bushing.

The integrated sensing capacitor is operable as a high-voltage capacitor in a voltage divider (the "sensing voltage divider") for sensing the elevated voltage with a high degree of precision. The connection element is electrically connected to the sensing voltage divider such that the sensing voltage divider can sense the elevated voltage of the connection element. For that purpose, the connection element on elevated voltage is electrically connected to the high-voltage electrode of the sensing capacitor in the sensored insulation plug which in turn is operable as a high-voltage capacitor in the sensing voltage divider for sensing the elevated voltage.

The high-voltage electrode of a sensored insulation plug according to the present disclosure is arranged in the high-voltage end portion of the insulation plug, as described below. A portion of the high-voltage electrode, or a portion of a contact piece, is exposed and externally accessible for establishing an electrical connection to the connection element of the separable connector.

In use, the high-voltage electrode may be connected not only electrically, but also mechanically to the connection element of the separable connector. This mechanical connection advantageously is an electrically conductive connection. The mechanical connection may be a direct mechanical connection, i.e. a portion of the high-voltage electrode is mechanically connected to the connection element without any intermediate element.

Alternatively, this connection may be an indirect mechanical connection, i.e. in use a portion of the high-voltage electrode is connected to the connection element via an intermediate element, which is electrically conductive. The sensored insulation plug may thus further comprise an intermediate element which is operable to mechanically and electrically connect the high-voltage electrode with the connection element. Such an intermediate element may be, for example, a contact piece. Such a contact piece may be connectable to the connection element of the separable connector, for example via a conductive threaded stud or screw that is threadedly connected to the contact piece on one side and that can, on the other side, be threadedly engaged with the connection element of the sensored insulation plug.

Hence in certain embodiments the sensored insulation plug further comprises a contact piece, operable to mechanically and electrically connect the high-voltage electrode with the connection element of the separable connector.

A contact piece of the sensored insulation plug according to the present disclosure may be the high-voltage-electrode, or it may comprise the high-voltage electrode. Where the contact piece comprises the high-voltage electrode, the contact piece may have an engagement portion to engage with an intermediate element connecting the contact piece electrically with the connection element of the separable connector, and an electrode portion forming the high-voltage electrode. The engagement portion and the electrode portion may be formed as a single piece, e.g. as a single piece of metal. Alternatively, they may be formed as separate elements.

The contact piece, or an engagement portion of the contact piece, may comprise a recess to connectingly engage a stud that is connected to the connection element of the separable connector. The contact piece, or an engagement portion of the contact piece, may comprise an internal or external thread to connectingly and threadedly engage a threaded stud that is connected to the connection element of the separable connector.

In certain preferred embodiments, the sensing electrode is shaped and arranged such as to be generally rotationally symmetric about the plug axis of the sensored insulation plug. In certain preferred embodiments, the high-voltage electrode is shaped and arranged such as to be generally rotationally symmetric about the plug axis of the sensored insulation plug. Where both electrodes are shaped and arranged such as to be generally rotationally symmetric about the plug axis, the high-voltage electrode and the sensing electrode may be arranged coaxially, or concentrically, with the sensing electrode being arranged around the high-voltage electrode. The sensing electrode being arranged around the high-voltage electrode implies that the sensing electrode, or at least an axial portion of the sensing electrode, is arranged radially outward from the high-voltage electrode and surrounds the high-voltage electrode.

Hence, in certain embodiments the plug body is rotationally symmetric about a plug axis, and the high-voltage electrode and the sensing electrode are arranged concentrically around the plug axis, and wherein the sensing electrode is arranged around the high-voltage electrode. The concentric arrangement helps provide for a reduced risk of electrical discharges. The arrangement of the sensing electrode around the high-voltage electrode may result in a larger capacitance of the sensing capacitor and a higher sensing accuracy of the sensing voltage divider.

In certain embodiments a shield electrode is arranged around the sensing electrode. The shield electrode may be held on ground potential. The shield electrode helps shield the sensing electrode against external electrical fields, which can result in a more precise sensing of the elevated voltage. The shield electrode may be embedded in the insulating material of the plug body. The shield electrode may have a cylindrical tubular shape. It may be arranged concentrically about the plug axis and coaxial with the sensing electrode.

The expression "embedded in the insulating material" as used herein refers to being surrounded completely by portions of the insulating material. An electrode is considered embedded in the insulating material if the insulating material of the plug body is cast or molded around the electrode. In a particular aspect, an element of the sensored insulation plug may be considered embedded in the insulating material if a major portion, e.g. more than 90% or more than 95%, of its exterior surface is in surface contact with the solidified insulating material. Surface contact, however, is not a prerequisite for being considered "embedded", as an embedded element may, for example, be arranged in a cavity formed by the insulating material without being in surface contact with the solidified insulating material. Embedding is beneficial in that it may improve electrical insulation of the embedded element and help protect the embedded element against detrimental mechanical or environmental impacts.

The high-voltage electrode of the sensing capacitor may be embedded in the insulating material. A portion of an embedded high-voltage electrode, or an entire embedded high-voltage electrode, may be in surface contact with the insulating material of the plug body.

The sensing electrode of the sensing capacitor is embedded in the insulating material forming the plug body. A portion of the embedded sensing electrode, or the entire sensing electrode, may be in surface contact with the insulating material of the plug body.

The sensing electrode may be electrically connected, or connectable, to a low-voltage capacitor or to a plurality of low-voltage capacitors, such that the sensing capacitor and the low-voltage capacitor(s) form a voltage divider for sensing the elevated voltage of a connection element of a separable connector. The sensing capacitor may be comprised in, or may form, the high-voltage portion of the sensing voltage divider, while the low-voltage capacitor(s) may be comprised in, or may form, the low-voltage portion of the sensing voltage divider.

The plug body may have a generally rotationally symmetric outer shape. In order to be usable with many existing separable connectors the plug body may have a generally frustoconical outer shape, such that it can fill a frustoconical rear cavity of a separable connector without leaving many or large voids between the inner surface of the rear cavity and the outer surface of the plug body. The outer shape of the sensored insulation plug according to the present disclosure may be generally symmetric about a plug axis, e.g. rotationally symmetric about a plug axis. The plug axis may be an axis which is parallel to a design insertion direction, i.e. a direction in which the sensored insulation plug, by design, is supposed to be inserted into a separable connector. The plug axis defines axial directions, which are directions parallel to the plug axis, and radial directions, which are directions orthogonal to the axial directions.

In axial directions a sensored insulation plug (and its plug body) comprises a high-voltage end portion and, at an opposite end in axial directions, an opposed low-voltage end portion. The high-voltage end portion is close to the connection element of the separable connector once the sensored insulation plug is inserted into the rear cavity of the separable connector. Where the insulation plug is frustoconical, the high-voltage end portion is the smaller-diameter end portion, while the low-voltage end portion is the larger-diameter end portion, which normally protrudes from the rear cavity when the plug is inserted. The low-voltage end portion may have an axial end face. The axial end face of the low-voltage end portion may be oriented orthogonally to the plug axis and faces away from the high-voltage electrode and the contact piece of the sensored insulation plug.

At its low-voltage end portion the sensored insulation plug may have an engagement feature, e.g. of a hexagonal shape, protruding axially such that it can be engaged by a wrench to rotate the insulation plug and thereby to engage it with the connection element of the separable connector. The engagement feature may be arranged symmetrically around the plug axis. Where the engagement feature comprises a hexagonal shape, the centre of the hexagonal shape may be arranged on the plug axis.

Advantageously a sensored insulation plug according to the present disclosure, and in particular the shape of the plug body of the sensored insulation plug, is adapted to conform to DIN EN 50180 or to DIN EN 50181, which are German industry standards for bushings. For use in other geographies, it may be more advantageous that the sensored insulation plug, and in particular the shape of the plug body of the sensored insulation plug, is adapted to conform to industry standard ANSI/IEEE 386. When referring to an industry standard herein, the latest version as in force on 20 May 2021 is meant, e.g. ANSI/IEEE standard 386-2016, published 14 October 2016, is deemed to be the latest version in force on 20 May 2021. Conformance to an industry standard, although not a requirement for sensored insulation plugs as described herein, may generally help obtain compatibility with a greater number of separable connectors.

Hence in certain embodiments the plug body is shaped such as to conform with the ANSI/IEEE standard 386 in its latest version as in force on 20 May 2021.

The sensored insulation plug according to the present disclosure comprises a plug body formed by one or more electrically insulating materials, for example by one or more solidified electrically insulating material. The shape of the plug body may generally determine the outer shape of the sensored insulation plug. For durability and for reliable functioning over years it is desirable that the plug body is mechanically rigid, has a high dielectric strength, exhibits little variation of its relative permittivity with changes in temperature over the operating temperature range, does not absorb water, and does not age.

A first portion of the plug body may be formed from a first solidified electrically insulating material. A second portion of the plug body may be formed from a second solidified electrically insulating material. In certain embodiments a first portion of the plug body at the the high-voltage end portion is formed from a first solidified electrically insulating material, and a second portion of the plug body at the low-voltage end portion is formed from a second solidified electrically insulating material.

In certain embodiments the plug body is formed by a first solidified electrically insulating material forming a recess at the low-voltage end portion of the sensored insulation plug. The recess is filled with a second solidified electrically insulating material.

The first electrically insulating material, and/or the second electrically insulating material used in some embodiments of the sensored insulation plug described herein, may be a solidified electrically insulating material. The first insulating material may be liquid during the manufacturing of the plug body and solidifies thereafter to form a rigid plug body. The second insulating material may be liquid during the process of filling the recess formed in the plug body, and solidifies thereafter to fill the recess and embed the circuit board in it. Solidification may be obtained by curing, hardening, crosslinking, or in other known manners. The first insulating material and/or the second insulating material may be, for example, a solidifiable, e.g. a hardenable or curable, liquid epoxy resin or a solidifiable, e.g. hardenable or curable, liquid mixture of an epoxy resin with other materials, such as fillers, or a solidifiable, e.g. hardenable or curable, polyurethane resin or a solidifiable, e.g. hardenable or curable, mixture of a polyurethane resin with other materials, such as fillers. Useful fillers are, for example, SiO₂ or Al₂O₃ or other electrically insulating inorganic materials. Alternatively, the first insulating material and/or the second insulating material may be or may comprise, for example, a ceramic material or any other suitable solid, electrically insulating material.

In certain embodiments the first insulating material and/or the second insulating material comprises an epoxy resin and, optionally, a filler, such as SiO₂ or Al₂O₃ or another electrically insulating inorganic material. Epoxy resins provide high electrical withstand, and much knowledge exists around molding or casting epoxy resins, furthermore these resins are available at moderate cost. Suitable fillers can help increase electrical withstand of an insulating material or to reduce its shrinkage upon solidifying. Where an insulating material is used as a dielectric in a capacitor, choosing a suitable filler may allow to adjust the coefficient of thermal expansion of the insulating material and thereby the variation of the capacitance of the sensing capacitor with temperature. In certain embodiments the second insulating material is a solidified two-component epoxy resin for room temperature curing. Generally, curing of a curable resin results in solidification of the resin. The solidified resin is the insulating material forming the plug body or filling a recess in the plug body.

The viscosity of a solidifiable insulating material in its liquid state is not critical, as long as it allows the liquid insulating material to be used, e.g. molded or cast, in known processes to form the plug body.

The sensing capacitor of the sensored insulation plug described herein is operable as a high-voltage capacitor in a sensing voltage divider, which in use is electrically connected between the connection element on elevated voltage and electrical ground, for sensing the elevated voltage of the connection element of the separable connector.

The sensing voltage divider comprises, in its high-voltage portion, the sensing capacitor of the sensored insulation plug described herein. In its low-voltage portion, the sensing voltage divider comprises one or more low-voltage capacitors. This low-voltage capacitor - or these low-voltage capacitors - may be comprised in the sensored insulation plug or may be separate from it. A low-voltage capacitor may be electrically connected or connectable with the sensing electrode, e.g. by a wire, a conductive trace on a circuit board, or in other ways.

The sensing voltage divider may be a capacitive voltage divider. In other words, both its high-voltage portion and its low-voltage portion may each consist of one or more capacitors, respectively, and may be free of impedance elements of other types, such as resistors or inductances. In certain embodiments the sensing voltage divider is a mixed voltage divider, in which the high-voltage portion comprises, beyond the sensing capacitor, an inductance or a resistor, and in which the low-voltage portion comprises a capacitor and/or an inductance and/or a resistor.

In certain embodiments, the high-voltage portion of the sensing voltage divider comprises, beyond the sensing capacitor, a plurality of capacitors, such as ten, fifteen, twenty, or thirty capacitors. While a greater number of capacitors helps stepping down the elevated voltage in smaller steps, arranging many capacitors linearly may result in the plug body being too short to accommodate this row of capacitors. To avoid this problem, a certain number of these capacitors can be replaced by a high-voltage resistor, according to the concept of the so-called Zaengl divider, known from certain fields of electrical engineering.

As used herein, the high-voltage portion of the sensing voltage divider is the portion that is electrically arranged between a signal contact, at which a divided voltage can be picked up, and a contact for connection to the elevated voltage which is to be sensed. The low-voltage portion of the sensing voltage divider is the portion that is electrically arranged between that signal contact and a contact for connection of the sensing voltage divider to electrical ground. The divided voltage varies proportionally with the elevated voltage, it is therefore also referred to herein as the "signal voltage". The dividing ratio, i.e. the proportionality factor between the elevated voltage and the signal voltage, depends on the ratio of the total impedance of the high-voltage portion to the total impedance of the low-voltage portion of the sensing voltage divider. By measuring the signal voltage of the signal contact and applying the proportionality factor, the elevated voltage of the connection element can be sensed. A signal wire may be connected to the signal contact to lead the signal voltage to some measurement circuitry outside the sensored insulation plug.

The sensing capacitor may be directly electrically connected to the elevated voltage of the connection element, that is, the sensing capacitor may be electrically connected to the connection element without any intermediate element. In particular, the high-voltage electrode of the sensing capacitor may be directly electrically connected to the elevated voltage, i.e. to the elevated voltage of the connection element. The high-voltage electrode may be directly electrically connected to the connection element. This direct electrical connection may be established, for example, through a contact piece, which is an electrically conductive mechanical element between the high-voltage electrode and the connection element of the separable connector.

The sensing capacitor has two electrodes, namely its high-voltage electrode and its sensing electrode, and a dielectric between the electrodes. The dielectric is formed by a portion of the electrically insulating material of the plug body in that some of the plug body's insulating material is arranged between the sensing electrode and the high-voltage electrode. More specifically, the dielectric may be formed by a first portion of the plug body in that some of the plug body's insulating material may be arranged between at least a portion of the sensing electrode and a portion of the high-voltage electrode.

In certain embodiments the sensing electrode is generally of a tubular shape and is arranged around the high-voltage electrode, e.g. concentrically arranged around the high-voltage electrode, or at least around an axial portion of the high-voltage electrode. The sensing electrode of the sensing capacitor may be connected to, or formed with, other components, e.g. components for support or electrical or mechanical connection of the sensing electrode, to form a sensing electrode assembly. Within a sensing electrode assembly, the sensing electrode is the element that is arranged opposite to the high-voltage electrode and that determines, in combination with the high-voltage electrode and the dielectric, the capacitance of the sensing capacitor.

The temperature sensor of a sensored insulation plug according to the present disclosure is arranged on the circuit board. It comprises a sensor probe which is in surface contact with, or thermally coupled to, the insulating material of the plug body. The temperature sensor can be of any type that is suitable to sense the temperature of the insulating material. Suitable types of temperature sensors include resistance thermometers, resistance temperature detectors, thermocouples, fiber-optic temperature sensors, and the like. The sensor probe is the portion of the temperature sensor which is sensitive to temperature. In other words, the sensor probe is operable to sense a temperature in the vicinity of the sensor probe. Where, for example, a fiber-optic temperature sensor comprises a gallium arsenide semiconductor crystal on the end of the optical fiber which varies its reflectivity with variation of its temperature, the gallium arsenide semiconductor crystal is the sensor probe of the fiber-optic temperature sensor.

In certain embodiments the sensor probe is arranged on the sensor body or is arranged such as to be in surface contact with the sensor body. This proximity may be advantageous in that electrical paths between the sensor probe and the sensor body can be short. In assembly of the sensored insulation plug, the proximity may allow treating the two components of the temperature sensor as a single component, thus saving assembly time. During molding, it may be beneficial if the liquid insulating material only needs to flow around one obstacle (sensor probe and sensor body jointly) rather than around two separate obstacles (probe and body separately). This may accelerate the molding process.

In certain embodiments, the sensor probe is embedded in the first insulating material, i.e. in the insulating material in which the sensing electrode is embedded and which forms the plug body . An embedding of the sensor probe - or embedding of the temperature sensor - often results in a direct and strong thermal coupling of the sensor probe to the insulating material, as no intermediate materials or elements are required for thermally coupling the sensor probe to the insulating material.

In certain embodiments the temperature sensor further comprises a sensor body. The sensor body may be adapted for attachment to a circuit board and/or for housing certain electronic components useful for temperature sensing. As opposed to the sensor body, the sensor probe is a temperature-sensitive portion of the temperature sensor.

In some of those embodiments the sensor body is arranged on the circuit board. This may facilitate electrical connection of the temperature sensor to a power supply or to other electric or electronic components by the conductive traces of the circuit board, and/or provide mechanical stability and a defined position of the sensor body.

In certain embodiments the sensor probe is arranged at a distance from the sensor body. This may allow the sensor probe to be located in a location in which the temperature is to be sensed, while the sensor body can be located in a location where it is, for example, easily accessible or easily connectable (like on the circuit board) or mechanically or thermally protected. In certain sensored insulation plugs according to the present disclosure, the sensor probe may be arranged between the sensing electrode and the high-voltage electrode, at a distance from the sensor body which may be arranged on the circuit board, located at an axial distance of several millimetres or several centimetres from the closest portion of the sensing electrode.

Where the sensor probe is arranged at a distance from the sensor body, the sensor probe may be connected with the sensor body by an umbilical through which digital or analogue signals can be transmitted between the sensor probe and the sensor body. The distance may be, for example, between 5 millimetres (mm) and 50 millimetres.

In certain embodiments of the sensored insulation plug according to the present disclosure, the sensor probe is arranged between the high-voltage electrode and the sensing electrode. The sensor probe is thus arranged in a location in which the temperature of the insulating material has a considerable impact on the dividing ratio of the sensing voltage divider and hence on the precision of the voltage sensor. In this critical location, the sensor probe is most useful in determining the temperature. In this location between the electrodes the sensor probe is arranged at a distance from the sensor body which may be arranged on the circuit board. The circuit board may be located at an axial distance of several millimetres or several centimetres from the closest portion of the sensing electrode.

In certain of these embodiments the temperature sensor is a fiber optic temperature sensor. Such sensors are typically free of electrically conductive elements, and generally neither their sensor probe nor, where present, their umbilical is electrically conductive. This allows the sensor probe to be arranged close to the high voltage electrode or between the high-voltage electrode and the sensing electrode without increasing the risk of electrical breakdown between the high voltage electrode and the temperature sensor or the sensor probe.

In certain embodiments the sensor probe comprises a temperature-dependent resistor. The temperature-dependent resistor may comprise, for example, platinum, nickel, or copper, or another suitable metal. Suitable metals have a well-known resistance/temperature relationship which is used to sense the temperature. In a specific embodiment the sensor probe comprises a platinum (Pt) resistor, such as a PT100 resistor.

In certain embodiments the temperature sensor comprises a silicon bandgap sensor probe. As is known, the voltage difference between two p-n junctions (e.g. diodes), operated at different current densities, is proportional to absolute temperature. A silicon bandgap temperature sensor makes use of the fact that the forward voltage of a silicon diode, which may be the base-emitter junction of a bipolar junction transistor (BJT), is temperature-dependent.

In certain embodiments the sensor probe comprises a thermocouple. A thermocouple produces a temperature-dependent voltage, and this voltage can be interpreted to sense the temperature.

In certain embodiments the temperature sensor is, or comprises, a digital temperature sensor, such as, for example, a DS18B20, 1-wire digital temperature sensor.

In certain embodiments the temperature sensor is, or comprises, a fiber optic temperature sensor. In some of these embodiments the sensor probe comprises a gallium arsenide semiconductor crystal. In some of these latter embodiments the sensor probe is connected with the sensor body by an umbilical through which digital or analogue signals can be transmitted between the sensor probe and the sensor body. The umbilical may be, or may comprise, an optical fiber.

The types of temperature sensors described above provide reliable high accuracy temperature sensing at moderate cost. Hence in certain embodiments the sensored insulation plug according to the present disclosure comprises a temperature-dependent electrical resistor, such as a PT100 resistor or a resistor comprising platinum, nickel, or copper, or wherein the temperature sensor comprises a silicon bandgap sensor probe, or a thermocouple, or a digital temperature sensor, or wherein the temperature sensor is a fiber optic temperature sensor comprising an optical fiber.

In order to perform a temperature correction on the voltage sensor, it may be desired that the temperature value sensed by the temperature sensor is made available outside the sensored insulation plug, so that a processing unit such as a remote terminal unit "RTU" can pick up the temperature value and use it to correct the output of the voltage sensor. Therefore, in certain embodiments, the sensored insulation plug of the present disclosure further comprises a temperature output wire, electrically connected to the temperature sensor and terminating outside of the plug body, operable to electrically transmit a temperature value sensed by the temperature sensor to an outside of the plug body.

The temperature output wire may be a shielded or an unshielded wire.

In other, alternative embodiments the sensored insulation plug further comprises a temperature output fibre, optically connected to the temperature sensor and terminating outside of the plug body, operable to optically transmit a temperature value sensed by the temperature sensor to an outside of the plug body.

For easier and more reliable transmission of the temperature value to an RTU, it may be useful to provide a connector on the sensored insulation plug with which a matching plug of a data cable can be mated, so that the temperature value is transmitted by the data cable to a processing device. Hence, in certain embodiments, the sensored insulation plug further comprises an externally accessible electrical connector, wherein the electrical connector comprises a connector contact to facilitate electrical connection to a corresponding plug contact of a matching plug, and wherein the temperature output wire is electrically connected to the connector contact. The temperature output wire is thus electrically terminated at the connector contact of the connector. The connector may be arranged, for example, on an outer surface of the sensored insulation plug, making it easily externally accessible.

An output (analogue or digital) of the temperature sensor is generally connected to a remote terminal unit ("RTU"). The RTU will often also receive the output, i.e. the signal voltage, of the sensing voltage divider and use the signal voltage to determine the value of the elevated voltage. The RTU can thus use the output of the temperature sensor to determine the temperature of the insulating material of the plug body and use this plug body temperature to apply a correction to the value of the elevated voltage in order to obtain a temperature-corrected, more precise value of the elevated voltage.

The sensor probe is thermally coupled (via surface contact or in another manner) to the first electrically insulating material so that the temperature sensor can accurately sense the temperature of the insulating material of which the plug body is formed and in which the sensing electrode is embedded. In certain preferred embodiments the sensor probe is thermally conductively coupled to the first insulating material. In these embodiments a thermally highly conductive material conducts heat between the insulating material and the sensor probe. In the context of the present disclosure, thermally highly conductive materials are materials that have a thermal conductivity of 10 W/(m * K) at room temperature or higher.

Where the circuit board is embedded in the second insulating material, the sensor probe may be arranged in the first insulating material, for example, or in the second insulating material. In embodiments in which the sensor probe is arranged in the first insulating material, thermal coupling of the sensor probe to the first insulating material may be achieved through a surface contact between the sensor probe and a portion of the first insulating material or in other ways, e.g. via thermally highly conductive material that is in surface contact with both the sensor probe and a portion of the first insulating material.

In embodiments in which the sensor probe is arranged in the second insulating material, thermal coupling of the sensor probe to the first insulating material may be achieved through a surface contact between the sensor probe and a portion of the second insulating material and a surface contact between the second insulating material and the first insulating material. Thermal coupling of the sensor probe to the second insulating material may (alternatively or in addition) be achieved through a surface contact between the sensor probe and a portion of the second insulating material or in other ways, e.g. via thermally highly conductive material that is in surface contact with both the sensor probe and a portion of the second insulating material.

In certain embodiments, therefore, the sensored insulation plug further comprises a thermally highly conductive material, such as gold, silver, copper, aluminium or alloys thereof, arranged between, and in surface contact with, the sensor probe and a portion of the first insulating material for enhancing a thermal coupling between the portion of the first insulating material and the sensor probe, wherein a thermally highly conductive material is a material that has a thermal conductivity of 10 W/(m * K) or more at room temperature. In certain embodiments the sensored insulation plug further comprises a thermally highly conductive material, such as gold, silver, copper, aluminium or alloys thereof, arranged between, and in surface contact with, the sensor probe and a portion of the second insulating material for enhancing a thermal coupling between the portion of the second insulating material and the sensor probe, wherein a thermally highly conductive material is a material that has a thermal conductivity of 10 W/(m * K) or more at room temperature.

Where the sensor probe is embedded in an insulating material, and hence is directly thermally coupled to the insulating material, relatively thin layers of an interface material having high thermal conductivity (as defined above) may be arranged between the sensor probe and the insulating material. Such layers may help to provide a larger contact surface - and hence better thermal coupling - between the sensor probe and the insulating material. Such an interface material may comprise, for example, silver, gold, copper, aluminium, or another metal, or even diamond.

An embedding if the sensor probe or an embedding of the temperature sensor results in a direct and strong thermal coupling of the sensor probe to the insulating material, as no intermediate materials or elements are required for thermally coupling the sensor probe to the insulating material.

Thus in certain scenarios no intermediate layer of a thermally conductive material may be needed, and it may be sufficient to provide a surface contact between the sensor probe and a portion of the insulating material. Therefore, in certain embodiments the sensor probe is in surface contact with a portion of the first insulating material. In certain embodiments the sensor probe is in surface contact with a portion of the second insulating material.

The plug body of a sensored insulation plug according to the present disclosure may have an elevated temperature due to, for example, elevated ambient temperature, or due to an elevated temperature (e.g. through ohmic losses in an imperfect electrical contact between the conductor in the separable connector and a bushing to which it is incompletely connected) of the separable connector into which the sensored insulation plug is inserted. Some of these effects may cause a temperature gradient in the plug body of the sensored insulation plug and a corresponding uneven temperature distribution in the plug body.

For the purposes of the present disclosure, such a temperature gradient may not be taken into account. In a first approximation a temperature sensed at any location within the plug body - or on its surface - can be assumed to be the temperature of the entire plug body, consciously ignoring the minute temperature differences between different portions of the plug body. The temperature of the plug body sensed at the location of the sensor probe is deemed sufficiently precise to perform a temperature correction of the dividing ratio of the sensing voltage divider of the voltage sensor.

The plug body has a certain thermal inertia due to its mass, and its insulating material has a limited heat conductivity. Although the temperature sensor may be adapted to pick up rapid temperature changes, the plug body is unlikely to change its temperature significantly within seconds. The sensored insulation plug and its temperature sensor may thus be designed to sense relatively low temperature change rates of, for example, between 1 Kelvin per minute and 10 Kelvin per minute.

The sensored insulation plug according to the present disclosure comprises a circuit board. The circuit board supports the temperature sensor. A circuit board is generally a cost-effective means to support the temperature sensor mechanically. A reliable support for the temperature sensor is important not only for long-term reliability of the temperature sensor, but also for holding the temperature sensor in place during a molding step of the plug body where liquid molding material flows under pressure around the temperature sensor, with a risk of displacement of the temperature sensor. Also, a circuit board facilitates the making of electrical connections of the temperature sensor to other elements, such as a connection to a temperature output wire of the temperature sensor or to a power supply.

The circuit board comprises a signal contact. The signal conduct is electrically conductively connected to the sensing electrode. Thereby the voltage of the sensing electrode is made available at the signal contact. The signal contact on the circuit board provides an easily accessible connection point, during assembly, for connecting a signal wire or a signal connector to the signal contact that picks up the signal voltage of the sensing voltage divider and makes it available outside of the plug body, e.g. at a signal connector on the outer surface of the plug body.

The temperature sensor is arranged on the circuit board. It may be arranged on the circuit board and supported by the circuit board. The temperature sensor may be soldered to the circuit board. This may help keep the temperature sensor in place during a molding step and may make assembly of the sensored insulation plug easier, as no connecting wires are needed to connect the temperature sensor to other electrical elements on the circuit board.

Where the temperature sensor comprises a sensor body and a sensor probe, the sensor body may be arranged on the circuit board. The sensor probe may or may not be arranged on the circuit board. This latter scenario would allow the sensor probe to be located at a certain distance from the circuit board. The sensor probe may, for example, be located closer to the dielectric of the sensing capacitor, resulting in a more accurate sensing of temperature of the dielectric and potentially in a more accurate determination of the dividing ratio of the sensing voltage divider.

Where the temperature sensor comprises a sensor body and a sensor probe, the sensor probe may be arranged on the circuit board. This may be advantageous in that the sensor probe can be mechanically supported by the circuit board, thus helping to avoid displacement of the sensor probe by a flow of liquid insulating material when the plug body is formed by molding liquid insulating material around the circuit board.

In certain embodiments the circuit board is embedded in the first insulating material. In certain of these embodiments the circuit board and the temperature sensor are embedded in the second insulating material. Embedding the circuit board in the first insulating material can facilitate thermal coupling of the temperature sensor probe and of the sensor probe to the first insulating material, especially in scenarios in which the sensor probe is arranged on the circuit board or in its vicinity. Embedding can help provide good protection of the circuit board and of the temperature sensor against mechanical impacts and environmental effects like humidity or water, thereby increasing the reliability of the sensored insulation plug.

In certain embodiments the circuit board is arranged in a recess which is formed in the plug body and filled at least partially with a second insulating material, wherein the circuit board is embedded in the second insulating material. The sensor probe may be thermally coupled to the first insulating material by the second insulating material. Alternatively, the sensor probe may be in surface contact with the first insulating material.

In certain of these embodiments the circuit board and the temperature sensor are embedded in the second insulating material. Embedding the circuit board in the second insulating material can help provide good protection of the circuit board and of the temperature sensor against mechanical impacts and environmental effects like humidity or water, thereby increasing the reliability of the sensored insulation plug. Furthermore, the second insulating material can be cast or molded around the circuit board after the first insulating material has solidified and the plug body is formed. This allows assembling the circuit board on the plug body at a later stage in the production process, which makes the manufacturing process more flexible. Also, a pre-produced plug body can be equipped with different circuit boards according to momentary customer demand, to obtain electrically different varieties of the sensored insulation plug in a cost-effective manner.

The sensing electrode may extend orthogonally from a support platform supporting the sensing electrode. The support platform may be, or comprise, the circuit board. In certain embodiments the circuit board supports the sensing electrode. The circuit board may be arranged such that its thickness direction extends parallel to the plug axis (i.e. in axial directions) of the sensored insulation plug and its major surfaces extend in radial directions. Having the circuit board support the sensing electrode facilitates shorter electrical connections of the sensing electrode to other electric or electronic components, such as those arranged on the circuit board. It also can facilitate soldering of the sensing electrode to the circuit board, which is a cost-effective manner of attaching the sensing electrode. Furthermore, where the circuit board supports the sensing electrode, no additional support element for the sensing electrode is needed, which can reduce cost and assembly time.

A rise in the temperature of the plug body may be indicative of an imperfect electrical contact between the power cable and the network apparatus at the connection element of the separable connector. Such an imperfect electrical contact generally causes ohmic losses which heat up the connection element. As the plug body of the sensored insulation plug is, in use, thermally coupled with the connection element via the contact piece, the plug body will heat up as well.

However, a higher temperature of the plug body might also be caused by a rise in ambient temperature, i.e., a higher temperature of the ambient air (or more generally, the ambient gas, where air is considered a gas) in which the sensored insulation plug is operated. To take proper account of the ambient gas temperature, and to help differentiate a temperature rise caused by ohmic losses from one caused by hot weather, a thermometer or thermosensor may be used which senses the temperature of the ambient gas. If the temperature of the plug body rises while the ambient gas temperature remains unchanged, a hotter plug body is a stronger indicator for an imperfect electrical connection.

Therefore, in certain embodiments, the sensored insulation plug according to the present disclosure further comprises a thermosensor for sensing a temperature of ambient gas outside of the sensored insulation plug.

The thermosensor may comprise, for example, a temperature-dependent electrical resistor, such as a PT100 resistor or a resistor comprising platinum, nickel, or copper, or the thermosensor may comprise a silicon bandgap sensor probe, or a thermocouple, or a digital temperature sensor, or the thermosensor is a fiber optic thermosensor comprising an optical fiber. The thermosensor may be thermally insulated from the plug body. The thermosensor may be thermally coupled to ambient gas outside of the sensored insulation plug.

By replacing a conventional insulation plug in a separable connector with a sensored insulation plug as described herein, the separable connector can be upgraded to then comprise a high-precision voltage sensor. The present disclosure therefore also provides a medium-voltage or high-voltage separable connector, mountable to an end of a power cable and comprising a rear cavity and a connection element on elevated voltage, electrically connectable to the power cable and accessible through the rear cavity; wherein the separable connector comprises a sensored insulation plug as described herein, inserted into the rear cavity, wherein the high-voltage electrode is electrically connected to the connection element.

Sensored insulation plugs according to the present disclosure can advantageously be used in power distribution networks for high-precision sensing of the elevated voltage at a specific location of a power line, e.g. at a switchgear or at a transformer. Where a separable connector is used to connect a power cable to a switchgear or to a transformer, the sensored insulation plug can be inserted into the rear cavity of the separable connector. By replacing a conventional insulation plug in a separable connector with a sensored insulation plug as described herein, the separable connector can be upgraded to now comprise a high-precision voltage sensor, and the network can be upgraded to a high-accuracy sensored network without replacement of larger elements and without power outage, simply by replacing traditional insulation plugs with sensored insulation plugs according to the present disclosure.

The present disclosure therefore also provides a power distribution network for distributing electrical power at medium or high voltages, the network comprising
a) a power cable for conducting electrical energy in the power distribution network at an elevated voltage,
b) a medium-voltage or high-voltage separable connector, mounted to an end of the power cable and having a rear cavity and a connection element on elevated voltage, electrically connected to the power cable and accessible through the rear cavity; and
c) a sensored insulation plug as described herein, inserted into the rear cavity, wherein the high-voltage electrode is electrically connected to the connection element.

Where the sensored insulation plug comprises a temperature output wire electrically connected to the temperature sensor and terminating outside of the plug body, operable to electrically transmit a temperature value sensed by the temperature sensor to an outside of the plug body, the present disclosure also provides a method of installing a sensored insulation plug as described herein, comprising electrically connecting the temperature output wire to a processing device, such as to an RTU, or to a sensing device.

The invention will now be described in more detail with reference to the following Figures exemplifying particular embodiments:
- Fig. 1: Sectional view of a separable connector and a first sensored insulation plug according to the present disclosure;
- Fig. 2: Circuit diagram of a voltage divider in which a sensored insulation plug according to the present disclosure can be used;
- Fig. 3: Sectional view of a first circuit board and a temperature sensor, usable in a sensored insulation plug according to the present disclosure;
- Fig. 4: Sectional view of a second circuit board and a temperature sensor, usable in a sensored insulation plug according to the present disclosure;
- Fig. 5: Sectional view of the first sensored insulation plug;
- Fig. 6: Sectional view of a second sensored insulation plug according to the present disclosure; and
- Fig. 7: Sectional view of a third sensored insulation plug according to the present disclosure.

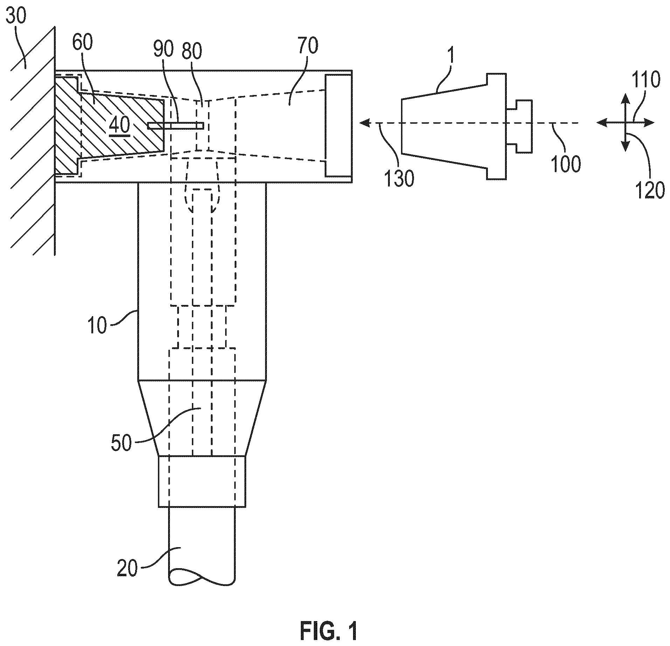

The sectional view of **Figure** 1 illustrates a separable connector 10 and a first sensored insulation plug 1 according to the present disclosure. The separable connector 10 is arranged at an end of a medium-voltage power cable 20 and connects, via a bushing 40, the power-carrying central conductor 50 of the cable 20 to a medium-voltage switchgear 30 in a power distribution network of a national grid.

The separable connector 10 is a T-shaped separable connector 10 and comprises a front cavity 60 for receiving the bushing 40, and a rear cavity 70 for receiving an insulation plug of a matching shape. The insulation plug may be a traditional insulation plug without elements of a sensor, or it may be a sensored insulation plug 1 according to the present disclosure, shown in Figure 1 to the right of the rear cavity 70, before being inserted into the rear cavity 70. Like traditional insulation plugs, a sensored insulation plug 1 according to the present disclosure serves to electrically insulate a connection element 80 of the separable connector 10, which is electrically connected to the central conductor 50 of the cable 20 and can be electrically and mechanically connected to a conductive component of the bushing 40 via a threaded stud 90. In use, the connection element 80 is on the elevated voltage of the central conductor 50 of the cable.

A sensored insulation plug 1 according to the present disclosure, just like a traditional insulation plug, has an overall frusto-conical outer shape, generally rotationally symmetric about a plug axis 100 which defines axial directions 110 and radial directions 120, which are directions orthogonal to the axial directions 110. The sensored insulation plug 1 can be inserted into the rear cavity 70 by moving it axially in an axial insertion direction 130 into the rear cavity 70 where it can be threadedly engaged - and thereby electrically connected - with the connection element 80 on elevated voltage. The geometry of the sensored insulation plug 1 is adapted to conform to ANSI/IEEE standard 386, but other geometries can be used as well, provided they match with the geometry of the rear cavity 70.

The sensored insulation plug 1 comprises an integrated sensing capacitor which can be electrically connected to the connection element 80 on elevated voltage and which is operable as a high-voltage capacitor in a sensing voltage divider for sensing the elevated voltage, as will be explained in the context of the other Figures.

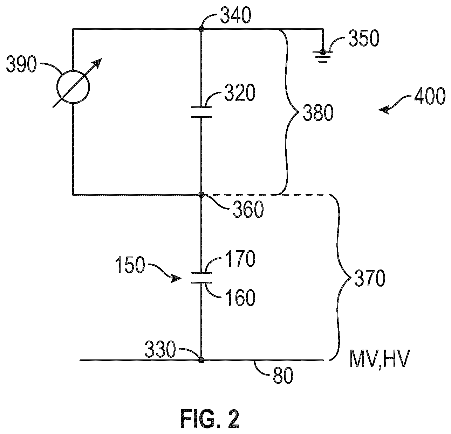

**Figure** 2 is a circuit diagram of a sensing voltage divider 400 for sensing the elevated voltage of the separable connector 10 in which a sensored insulation plug 1 of the present disclosure can be used.

The sensing voltage divider 400 for sensing the elevated voltage of the separable connector 10 is shown electrically connected to the connection element 80 of the separable connector 10 on medium or high (i.e. elevated) voltage. The sensing voltage divider 400 comprises a high-voltage capacitor 150, which is the integrated sensing capacitor 150 in the sensored insulation plug 1 described above, and a low-voltage capacitor 320. These two capacitors 150, 320 are electrically connected in series between a high-voltage contact 330 on elevated voltage and a low-voltage contact 340, held on electrical ground 350.

The high-voltage contact 330 facilitates electrical connection of the sensing voltage divider 400 and in particular of its sensing capacitor 150 to the connection element 80 on elevated voltage. The low-voltage contact 340 facilitates connection of the sensing voltage divider 400 to electrical ground 350.

A signal contact 360 is arranged electrically between a high-voltage portion 370 and a low-voltage portion 380 of the sensing voltage divider 400. At the signal contact 360, a divided voltage, also referred to herein as the signal voltage, can be picked up, which varies proportionally with the elevated voltage of the connection element 80. The dividing ratio, i.e. the proportionality factor between the elevated voltage and the signal voltage, depends on the ratio of the total impedance of the high-voltage portion 370 to the total impedance of the low-voltage portion 380 of the voltage divider 400. By measuring the signal voltage of the signal contact 360, such as by using a voltmeter 390, and applying the proportionality factor, the elevated voltage of the connection element 80 can be sensed.

In the illustrated embodiment, the high-voltage portion 370 comprises only one capacitor, namely the integrated sensing capacitor 150, with its high-voltage electrode 160 and its sensing electrode 170. In other embodiments the high-voltage portion 370 may comprise, beyond the integrated sensing capacitor 150, one or more further capacitors. Generally, it may comprise, beyond the integrated sensing capacitor 150, one or more further impedance elements, such as one or more resistors and/or one or more inductors.

Similarly, in the illustrated sensing voltage divider 400, the low-voltage portion 380 comprises only one capacitor, namely the low-voltage capacitor 320. In other embodiments the low-voltage portion 380 may comprise, beyond the low-voltage capacitor 320, one or more further capacitors. More generally, it may comprise, beyond the low-voltage capacitor 320, one or more further impedance elements, such as one or more resistors and/or one or more inductors.

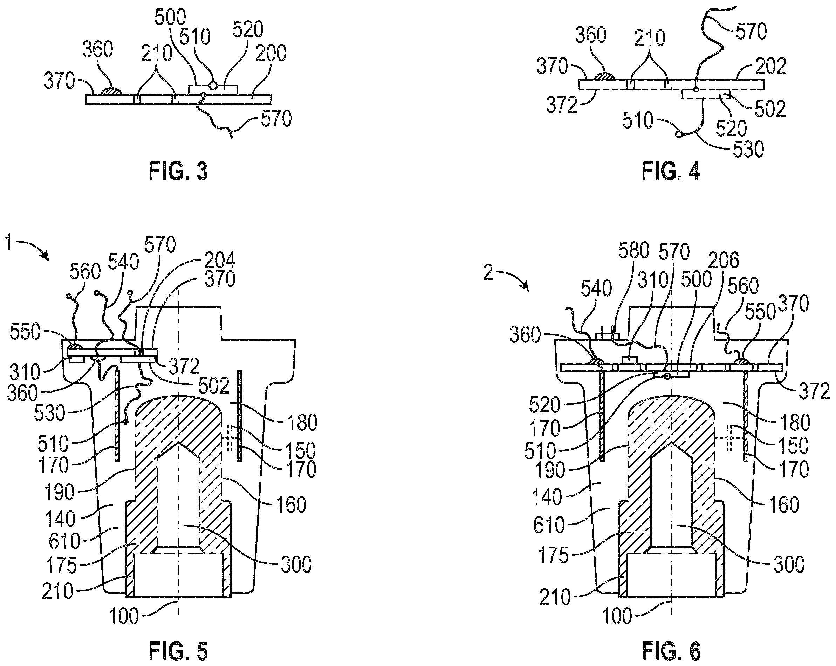

**Figure** 3 shows, in a sectional view, a first circuit board 200 and a first temperature sensor 500, as usable in sensored insulation plugs 1, 2 according to the present disclosure. The first circuit board 200 is a flat, rigid circuit board 200, made of FR4 glass fiber reinforced epoxy laminate material. The circuit board 200 comprises through-holes 210 or vias 210 along its thickness direction to facilitate flow of liquid insulating material 610 through the circuit board 200 when the plug body 140 is molded from a solidifiable insulating material 610.

The circuit board 200 comprises a signal contact 360 on its upper major surface 370. In a sensored insulation plug 1, 2 according to the present disclosure the signal contact 360 is electrically conductively connected to the sensing electrode 170 and in use the signal voltage can be picked up at the signal contact 360. In the embodiment of Figure 3 the signal contact 360 is a solder point 360 to facilitate electrical and mechanical connection of a wire, such as a signal wire 540 as described below, to the signal contact 360.

The first temperature sensor 500 is arranged on the upper major surface 370 of the first circuit board 200. The temperature sensor 500 comprises a sensor probe 510 at which the temperature is sensed. The sensor probe 510 of the first temperature sensor 500 is arranged on a body 520 of the temperature sensor 500. The body 520 of the temperature sensor 500 is arranged on the circuit board 200 and attached to the circuit board 200 by soldering.

The upper major surface 370 of the circuit board 200 is provided with conductive traces (not shown) which facilitate electrical connection of electrical or electronic elements with each other and/or with the signal contact 360 or the temperature sensor 500.

A temperature output wire 570 transmits the temperature value generated by the temperature sensor 500 in analogue or digital format away from the temperature sensor 500. The temperature output wire 570 may, for example, be connected to a processing device which performs calculations using the temperature value.

**Figure 4** illustrates, in a sectional view, a second circuit board 202 and a second temperature sensor 502, as usable in sensored insulation plugs 1, 2 according to the present disclosure. The second circuit board 202 is identical with the first circuit board 200 described above, except for any differences expressly pointed out.

The second temperature sensor 502 is arranged on the lower major surface 372 of the circuit board 202. The sensor probe 510 of the second temperature sensor 502 is arranged remote from the body 520 of the temperature sensor 502 and is connected to the body 520 by a flexible umbilical 530. The flexible umbilical 530 allows the temperature probe 510 to be located at a distance from the body 520 of the temperature sensor 502, such as between the sensing electrode 170 and the high-voltage electrode 160 of the sensored insulation plug 1, 2. While the sensor body 520 is attached conveniently to the circuit board 202, for example by soldering, the sensor probe 510 can be arranged at a location remote from the sensor body 520 if the knowledge of the local temperature at that location is particularly important.

**Figure 5** shows, in a longitudinal sectional view, the first sensored insulation plug 1 according to the present disclosure of Figure 1 in greater detail. The sensored insulation plug 1 comprises a plug body 140 of an electrically insulating hardened resin 610 and an integrated sensing capacitor 150, formed by a high-voltage electrode 160 and a sensing electrode 170, which are both rotationally symmetric about a plug axis 100. The dielectric of the primary capacitor 150 is formed by a portion 180 of the insulating material 610 of the plug body 140, located between the high-voltage electrode 160 and the sensing electrode 170.

The high-voltage electrode 160 is generally rotationally symmetric about the plug axis 100 and is comprised in an electrode portion 190 of a contact piece 175 made of conductive metal. The contact piece 175 is generally rotationally symmetric about the plug axis 100 and has, further to the electrode portion 190, an engagement portion 210 for mechanical engagement with an intermediate element connecting the contact piece 175 electrically with the connection element 80 of the separable connector 10. The electrode portion 190 forms the high-voltage electrode 160. The engagement portion 210 and the electrode portion 190 are formed as a single piece of metal.

The contact piece 175 comprises a threaded recess 300 to connectingly engage a stud for mechanical and direct, i.e. ohmic, electrical connection of the contact piece 175 to the connection element 80 of the separable connector 10. In use, the entire contact piece 175 and in particular its electrode portion 190 are on the elevated voltage of the connection element 80 of the separable connector 10.

The sensing electrode 170 is a stainless-steel sheet of generally tubular shape and is arranged concentrically around the high-voltage electrode 160. The sensing electrode 170 is completely surrounded by the insulating material 610 of the plug body 140, in other words it is embedded in the insulating material 610. In particular, a portion 180 of the insulating material 610 is present between the sensing electrode 170 and the high-voltage electrode 160, so that the insulating material 610 forms a dielectric of the primary capacitor 150.

The insulating material 610 of the plug body 140 is a solidified epoxy resin. In manufacturing the sensored insulation plug 1, the resin in its liquid state is cast or molded around the high-voltage electrode 160 and the sensing electrode 170 in a mold that determines the outer shape of the sensored insulation plug 1. The resin is then cured or hardened to solidify, resulting in a solid insulating plug body 140 in which the sensing electrode 170 is embedded.

The electrical breakdown strength of the insulating material 610 is high enough to reliably prevent electric discharges between the high-voltage electrode 160 on elevated voltage and the sensing electrode 170.

Apertures (not shown) in the sensing electrode 170 facilitate, during production of the sensored insulation plug 1, the flow of liquid insulating material 610 into the space between the sensing electrode 170 and the high-voltage electrode 160.

The sensored insulation plug 1 comprises a flat, rigid circuit board 204, embedded in the plug body 140. The circuit board 204 is identical with the second circuit board 202 of Figure 4, except for the differences described here. The circuit board 204 comprises conductive traces by which electric and electronic components (not shown), arranged on the upper surface 370 and on the lower surface 372 of the circuit board 204, are electrically connected with each other. In particular, a low-voltage capacitor 310 is arranged on the lower surface 372 of the circuit board 204. This low-voltage capacitor 310 is electrically connected in series between the sensing electrode 170 and a grounding contact 550 held on electrical ground 350. The grounding contact 550 corresponds to the low-voltage contact 340 of the sensing voltage divider 400 of Figure 2. The grounding contact 550 can be electrically connected to electrical ground by a grounding wire 560, leading from the grounding contact 550 on the embedded circuit board 204 to outside of the plug body 140 of the sensored insulation plug 1.

The low-voltage capacitor 310 forms the low-voltage portion 380 of the sensing voltage divider 400 for sensing the elevated voltage, with the integrated sensing capacitor 150 forming the high-voltage portion 370 of the sensing voltage divider 400.

The divided voltage of the sensing voltage divider 400 can be accessed at a signal contact 360 on the lower major surface 372 of the circuit board 204. An end of a signal wire 540 is connected to the signal contact 360 and leads to outside the plug body 140. At its other, external end, the signal wire 540 makes the signal voltage available outside the sensored insulation plug 1. The signal voltage varies proportionally with the elevated voltage of the high-voltage electrode 160, so that the elevated voltage of the high-voltage electrode 160 - and thereby the elevated voltage of the connection element 80 of the separable connector 10 - can be determined by measuring the signal voltage.

A temperature sensor 502 is arranged on the lower major surface 372 of the circuit board 204. The temperature sensor 502 is identical with the second temperature sensor 502 described above in the context of Figure 4, except where any differences are expressly described. The sensor body 520 of the temperature sensor 502 is soldered to the circuit board 204. The umbilical 530 connects the sensor probe 510 with the sensor body 520. The sensor probe 510 is arranged in the space between the high-voltage electrode 160 and the sensing electrode 170. This space is filled with a portion 180 of the insulating material 610. The sensor probe 510 senses the temperature of the insulating material 610 in this location, because temperature variations of the insulating material 610 in the space between the electrodes 160, 170 of the sensing capacitor 150 cause a change in capacitance of the sensing capacitor 150 and a corresponding change in the dividing ratio of the sensing voltage divider 400. By the temperature sensor 502 sensing this temperature, such variations can be taken into account when determining the elevated voltage.

A temperature output wire 570 transmits the value of the sensed temperature from the temperature sensor 502 to outside the sensored insulation plug 1 for further processing.

**Figure** 6 illustrates, in a longitudinal sectional view, a second sensored insulation plug 2 according to the present disclosure. It is identical to the first sensored insulation plug 1 described above, except for the differences described here.

The second sensored insulation plug 2 comprises a flat, rigid circuit board 206, embedded in the plug body 140. The circuit board 206 is identical with the first circuit board 200 of Figure 3, except for the differences described here. The circuit board 206 comprises conductive traces (not shown) by which electric and electronic components, arranged on the upper surface 370 and on the lower surface 372 of the circuit board 206, are electrically connected with each other. In particular, a low-voltage capacitor 310 is arranged on the upper surface 370 of the circuit board 206. This low-voltage capacitor 310 is electrically connected in series between the sensing electrode 170 and a grounding contact 550 held on electrical ground 350. The grounding contact 550 can be electrically connected to electrical ground 350 by a grounding wire 560, leading from the grounding contact 550 on the embedded circuit board 204 to outside of the sensored insulation plug 2. The grounding contact 550 corresponds to the low-voltage contact 340 of the sensing voltage divider 400 of Figure 2.

The low-voltage capacitor 310 forms the low-voltage portion 380 of the sensing voltage divider 400 for sensing the elevated voltage, with the integrated sensing capacitor 150 forming the high-voltage portion 370 of the sensing voltage divider 400.

The divided voltage of the sensing voltage divider 400 can be accessed at a signal contact 360 on the upper major surface 370 of the circuit board 206. A signal wire 540 makes the signal voltage available outside the sensored insulation plug 2. The signal voltage varies proportionally with the elevated voltage of the high-voltage electrode 160, so that the elevated voltage of the high-voltage electrode 160 - and thereby the elevated voltage of the connection element 80 of the separable connector 10 - can be sensed by measuring the signal voltage.

A temperature sensor 500 is arranged on the lower major surface 372 of the circuit board 206. The temperature sensor 500 is identical with the first temperature sensor 500 described above in the context of Figure 3, except where any differences are expressly described. The body 520 of the temperature sensor 500 is soldered to the circuit board 206 for mechanical support and electrical connection. The sensor probe 510 of the temperature sensor 500 is arranged on the body 520 of the temperature sensor 500. The sensor probe 510 senses the temperature of the insulating material 610 in the vicinity of the temperature sensor body 520. Temperature variations of the insulating material 610 of the plug body 140 cause a change in capacitance of the sensing capacitor 150 and a corresponding change in the dividing ratio of the sensing voltage divider 400. By the temperature sensor 500 sensing this temperature, such variations can be taken into account when determining the elevated voltage.

A temperature output wire 570 transmits the value of the sensed temperature from the temperature sensor 500 to a connector 580. The temperature output wire 570 is connected to a pin of the connector 580. The value of the sensed temperature can be picked up at that connector pin and be transmitted further to a processing device which can process the value of the sensed temperature, along with the divided voltage, to calculate the value of the elevated voltage with greater precision. The connector 580 facilitates convenient electrical connection of its pins to corresponding contacts of a matching plug (not shown).

In other embodiments, not shown here, the signal wire 540 and/or the grounding wire 560 are each connected to respective pins of the same connector 580 to which the temperature output wire 570 is connected. Such a connector may facilitate an easier, quicker and more reliable electrical connection of a processing unit (such as an RTU) to the temperature sensor 500, to the grounding contact 550 and to the signal contact 360.

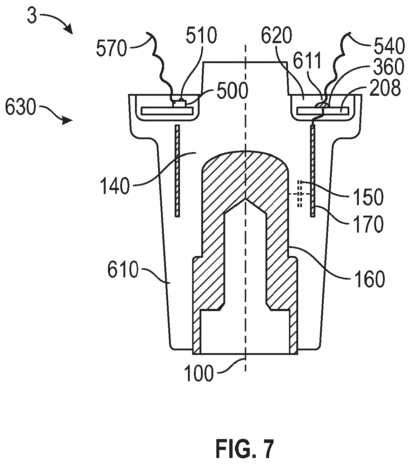

**Figure** 7 illustrates, in a longitudinal sectional view, a third sensored insulation plug 3 according to the present disclosure. It is identical to the second sensored insulation plug 2 described above, except for the differences described here.

The plug body 140 of the third sensored insulation plug 3 forms a circular recess 620 at the low-voltage end portion 630, centered about the plug axis 100. The recess 620 has a flat bottom to accommodate a circuit board.

A flat annular circuit board 208 is arranged in the recess 620. Arranged on the circuit board 208 are a temperature sensor 500 and a signal contact 360, with a signal wire 540 being connected to the signal contact 360 and leading to outside the plug body 140 to make the signal voltage available to an RTU.

The recess 620 is filled with a second electrically insulating material 611, namely a solidified epoxy resin material 611. During manufacturing, this material 611 was poured into the recess 620 while it was liquid, such as to embed the circuit board 208 in it and was then cured to solidify. The sensor probe 510 of the temperature sensor 500 is in surface contact with the second insulating material 611 and is thermally coupled to the first insulating material 610 by the second insulating material 611. This thermal coupling allows the temperature sensor 500 to sense the temperature of the first insulating material 610.

## Claims

1. Sensored insulation plug (1, 2, 3) for being inserted into a rear cavity (70) of a medium voltage or high-voltage separable connector (10) in a power distribution network of a national grid, and operable to insulate a connection element (80) of the separable connector on an elevated voltage and to sense the elevated voltage,
the sensored insulation plug comprising
a) a plug body (140) formed by a first electrically insulating material (610) and rotationally symmetric about a plug axis (100) defining axial directions (110) and radial directions (120) orthogonal to the axial directions;
b) an integrated sensing capacitor (150), operable as a high-voltage capacitor in a sensing voltage divider (400) for sensing the elevated voltage, the sensing capacitor comprising
i) a high-voltage electrode (160), electrically connected to the connection element (80) when the sensored insulation plug (1, 2, 3) is inserted into the rear cavity (70) of the separable connector (10);
ii) a sensing electrode (170), embedded in the first insulating material (610),
iii) a dielectric arranged between the high-voltage electrode (160) and the sensing electrode (170) and comprising a portion (180) of the first insulating material (610),
c) a circuit board (200, 202, 204, 206, 208) comprising a signal contact (360), electrically conductively connected to the sensing electrode (170),
**characterized by** further comprising
d) a temperature sensor (500, 502), arranged on the circuit board and comprising a sensor probe (510), operable to sense a temperature in the vicinity of the sensor probe (510), in surface contact with, or thermally coupled to, the first insulating material (610), for sensing a temperature of the first insulating material (610).

2. Sensored insulation plug (1, 2) according to claim 1, wherein the circuit board (200, 202, 204, 206) is embedded in the first insulating material (610).

3. Sensored insulation plug (3) according to claim 1, wherein the circuit board (208) is arranged in a recess (620) which is formed in the plug body (140) and filled at least partially with a second electrically insulating material (611), wherein the circuit board is embedded in the second insulating material (611).

4. Sensored insulation plug (1, 2) according to any one of the preceding claims, wherein the sensor probe (510) is embedded in the first insulating material (610).

5. Sensored insulation plug (1, 2, 3) according to any one of the preceding claims, wherein the temperature sensor (500, 502) further comprises a sensor body (520), wherein the sensor body (520) is arranged on the circuit board (200, 202, 204, 206, 208).

6. Sensored insulation plug (1) according to claim 5, wherein the sensor probe (510) is arranged at a distance from the sensor body (520).

7. Sensored insulation plug (1) according to any one of the preceding claims, wherein the sensor probe (510) is arranged between the high-voltage electrode (160) and the sensing electrode (170).

8. Sensored insulation plug (1, 2, 3) according to any one of the preceding claims, further comprising a temperature output wire (570), electrically connected to the temperature sensor (500, 502) and terminating outside of the plug body (140), operable to electrically transmit a temperature value sensed by the temperature sensor (500, 502) to an outside of the plug body (140).

9. Sensored insulation plug (1, 2, 3) according to any one of the preceding claims, further comprising a thermosensor for sensing a temperature of ambient gas outside of the sensored insulation plug.

10. Sensored insulation plug (1, 2, 3) according to any one of the preceding claims,
wherein the temperature sensor (500, 502) comprises a temperature-dependent electrical resistor, such as a PT100 resistor or a resistor comprising platinum, nickel, or copper, or
wherein the temperature sensor (500, 502) comprises a silicon bandgap sensor probe, or a thermocouple, or a digital temperature sensor, or wherein the temperature sensor (500, 502) is a fiber optic temperature sensor comprising an optical fiber.

11. Sensored insulation plug (1, 2) according to any one of the preceding claims, further comprising a thermally highly conductive material, such as gold, silver, copper, aluminium or alloys thereof, arranged between, and in surface contact with, the sensor probe (510) and a portion of the first insulating material (610) for enhancing a thermal coupling between the portion of the first insulating material (610) and the sensor probe (510), wherein a thermally highly conductive material is a material that has a thermal conductivity of 10 W/(m * K) or more at room temperature.

12. Sensored insulation plug (2, 3) according to claim 5, wherein the sensor probe (510) is arranged on the sensor body (520), or is arranged such as to be in surface contact with the sensor body (520).

13. Medium-voltage or high-voltage separable connector (10), mountable to an end of a power cable (20) and comprising a rear cavity (70) and a connection element (80) on elevated voltage, electrically connectable to the power cable (20) and accessible through the rear cavity (70);
wherein the separable connector (10) comprises a sensored insulation plug (1, 2, 3) according to any one of the preceding claims, inserted into the rear cavity (70), wherein the high-voltage electrode (160) is electrically connected to the connection element (80).

14. Power distribution network for distributing electrical power at medium or high voltages, the network comprising
a) a power cable (20) for conducting electrical energy in the power distribution network at an elevated voltage,
b) a medium-voltage or high-voltage separable connector (10), mounted to an end of the power cable (20) and having a rear cavity (70) and a connection element (80) on elevated voltage, electrically connected to the power cable (20) and accessible through the rear cavity (70); and
c) a sensored insulation plug (1, 2, 3) according to any one of claims 1-12, inserted into the rear cavity (70), wherein the high-voltage electrode (160) is electrically connected to the connection element (80).

15. Method of installing a sensored insulation plug (1, 2, 3) according to claim 8, comprising electrically connecting the temperature output wire (570) to a processing device, such as to an RTU, or to a sensing device.

## Patentansprüche

1. Mit einem Sensor versehener Isolierstecker (1, 2, 3) zum Einsetzen in einen hinteren Hohlraum (70) eines trennbaren Mittelspannungs- oder Hochspannungsverbinders (10) in einem Stromverteilungsnetz eines Verbundnetzes und der betriebsfähig ist, um ein Verbindungselement (80) des trennbaren Verbinders bei einer erhöhten Spannung zu isolieren und um die erhöhte Spannung abzugreifen, der mit einem Sensor versehene Isolierstecker aufweisend
a) einen Steckerkörper (140), der durch ein erstes elektrisch isolierendes Material (610) ausgebildet ist und um eine Steckerachse (100) herum drehsymmetrisch ist, die axiale Richtungen (110) und radiale Richtungen (120) definiert, die zu den axialen Richtungen orthogonal sind;
b) einen integrierten Messkondensator (150), der als ein Hochspannungskondensator in einem Messspannungsteiler (400) zum Abgreifen der erhöhten Spannung betriebsfähig ist, der Messkondensator aufweisend
i) eine Hochspannungselektrode (160), die mit dem Verbindungselement (80) elektrisch verbunden ist, wenn der mit einem Sensor versehene Isolierstecker (1, 2, 3) in den hinteren Hohlraum (70) des trennbaren Verbinders (10) eingesetzt ist;
ii) eine Messelektrode (170), die in das erste isolierende Material (610) eingebettet ist,
iii) ein Dielektrikum, das zwischen der Hochspannungselektrode (160) und der Messelektrode (170) angeordnet ist und aufweisend einen Abschnitt (180) des ersten isolierenden Materials (610),
c) eine Leiterplatte (200, 202, 204, 206, 208), aufweisend einen Signalkontakt (360), der mit der Messelektrode (170) elektrisch leitfähig verbunden ist,
**dadurch gekennzeichnet, dass** er ferner aufweist
d) einen Temperatursensor (500, 502), der auf der Leiterplatte angeordnet ist und aufweisend eine Sensorsonde (510), die betriebsfähig ist, um eine Temperatur in der Nähe der Sensorsonde (510) abzugreifen, die in Oberflächenkontakt mit dem ersten isolierenden Material (610) oder mit diesem thermisch gekoppelt ist, zum Abgreifen einer Temperatur des ersten isolierenden Materials (610).

2. Mit einem Sensor versehener Isolierstecker (1, 2) nach Anspruch 1, wobei die Leiterplatte (200, 202, 204, 206) in das erste isolierende Material (610) eingebettet ist.

3. Mit einem Sensor versehener Isolierstecker (3) nach Anspruch 1, wobei die Leiterplatte (208) in einer Ausnehmung (620) angeordnet ist, die in dem Steckerkörper (140) ausgebildet und mindestens teilweise mit einem zweiten elektrisch isolierenden Material (611) gefüllt ist, wobei die Leiterplatte in das zweite isolierende Material (611) eingebettet ist.

4. Mit einem Sensor versehener Isolierstecker (1, 2) nach einem der vorstehenden Ansprüche, wobei die Sensorsonde (510) in das erste isolierende Material (610) eingebettet ist.

5. Mit einem Sensor versehener Isolierstecker (1, 2, 3) nach einem der vorstehenden Ansprüche, wobei der Temperatursensor (500, 502) ferner einen Sensorkörper (520) aufweist, wobei der Sensorkörper (520) auf der Leiterplatte (200, 202, 204, 206, 208) angeordnet ist.

6. Mit einem Sensor versehener Isolierstecker (1) nach Anspruch 5, wobei die Sensorsonde (510) in einem Abstand von dem Sensorkörper (520) angeordnet ist.

7. Mit einem Sensor versehener Isolierstecker (1) nach einem der vorstehenden Ansprüche, wobei die Sensorsonde (510) zwischen der Hochspannungselektrode (160) und der Messelektrode (170) angeordnet ist.

8. Mit einem Sensor versehener Isolierstecker (1, 2, 3) nach einem der vorstehenden Ansprüche, ferner aufweisend einen Temperaturausgangsdraht (570), der mit dem Temperatursensor (500, 502) elektrisch verbunden ist und außerhalb des Steckerkörpers (140) endet, der betriebsfähig ist, um einen Temperaturwert, der durch den Temperatursensor (500, 502) abgegriffen wird, an eine Außenseite des Steckerkörpers (140) elektrisch zu übertragen.

9. Mit einem Sensor versehener Isolierstecker (1, 2, 3) nach einem der vorstehenden Ansprüche, ferner aufweisend einen Thermosensor zum Abgreifen einer Temperatur von Umgebungsgas außerhalb des mit einem Sensor versehenen Isoliersteckers.

10. Mit einem Sensor versehener Isolierstecker (1, 2, 3) nach einem der vorstehenden Ansprüche, wobei der Temperatursensor (500, 502) einen temperaturabhängigen elektrischen Widerstand aufweist, wie einen PT100-Widerstand oder einen Widerstand, aufweisend Platin, Nickel oder Kupfer, oder
wobei der Temperatursensor (500, 502) eine Silikonbandlückensensorsonde oder ein Thermoelement oder einen digitalen Temperatursensor aufweist oder wobei der Temperatursensor (500, 502) ein faseroptischer Temperatursensor ist, aufweisend eine optische Faser.

11. Mit einem Sensor versehener Isolierstecker (1, 2) nach einem der vorstehenden Ansprüche, ferner aufweisend ein thermisch hoch leitfähiges Material, wie Gold, Silber, Kupfer, Aluminium oder Legierungen davon, das zwischen der Sensorsonde (510) und einem Abschnitt des ersten isolierenden Materials (610) angeordnet ist und in Oberflächenkontakt mit diesen steht, zum Verbessern einer thermischen Kuppelung zwischen dem Abschnitt des ersten isolierenden Materials (610) und der Sensorsonde (510), wobei ein thermisch hoch leitfähiges Material ein Material ist, das bei Raumtemperatur eine thermische Leitfähigkeit von 10 W/(m * K) oder mehr hat.

12. Mit einem Sensor versehener Isolierstecker (2, 3) nach Anspruch 5, wobei die Sensorsonde (510) auf dem Sensorkörper (520) angeordnet ist oder derart angeordnet ist, um in Oberflächenkontakt mit dem Sensorkörper (520) zu stehen.

13. Trennbarer Mittelspannungs- oder Hochspannungsverbinder (10), der an einem Ende eines Stromkabels (20) montierbar ist und aufweisend einen hinteren Hohlraum (70) und ein Verbindungselement (80) bei erhöhter Spannung, das mit dem Stromkabel (20) elektrisch verbunden werden kann und durch den hinteren Hohlraum (70) zugänglich ist;
wobei der trennbare Verbinder (10) einen mit einem Sensor versehenen Isolierstecker (1, 2, 3) nach einem der vorstehenden Ansprüche aufweist, der in den hinteren Hohlraum (70) eingesetzt ist, wobei die Hochspannungselektrode (160) mit dem Verbindungselement (80) elektrisch verbunden ist.

14. Stromverteilungsnetz zum Verteilen von elektrischem Strom bei mittleren oder hohen Spannungen, das Netz aufweisend
a) ein Stromkabel (20) zum Leiten von elektrischer Energie in dem Stromverteilungsnetz bei einer erhöhten Spannung,
b) einen trennbaren Mittelspannungs- oder Hochspannungsverbinder (10), der an einem Ende des Stromkabels (20) montierbar ist und einen hinteren Hohlraum (70) und ein Verbindungselement (80) bei erhöhter Spannung hat, das mit dem Stromkabel (20) elektrisch verbunden und durch den hinteren Hohlraum (70) zugänglich ist; und
c) einen mit einem Sensor versehenen Isolierstecker (1, 2, 3) nach einem der Ansprüche 1 bis 12, der in den hinteren Hohlraum (70) eingesetzt ist, wobei die Hochspannungselektrode (160) mit dem Verbindungselement (80) elektrisch verbunden ist.

15. Verfahren zum Installieren eines mit einem Sensor versehenen Isoliersteckers (1, 2, 3) nach Anspruch 8, aufweisend das elektrische Verbinden des Temperaturausgangsdrahts (570) mit einer Verarbeitungsvorrichtung, wie mit einem RTU, oder mit einer Messvorrichtung.

## Revendications

1. Bouchon d'isolation à capteur (1, 2, 3) destiné à être inséré dans une cavité arrière (70) d'un connecteur séparable (10) moyenne tension ou haute tension dans un réseau de distribution de puissance d'un réseau national, et opérationnel pour isoler un élément de connexion (80) du connecteur séparable sur une tension élevée et pour détecter la tension élevée, le bouchon d'isolation à capteur comprenant
a) un corps de bouchon (140) formé par un premier matériau isolant électriquement (610) et symétrique en rotation autour d'un axe de bouchon (100) définissant des directions axiales (110) et des directions radiales (120) orthogonales aux directions axiales ;
b) un condensateur de détection (150) intégré, opérationnel en guise de condensateur haute tension dans un diviseur de tension de détection (400) pour détecter la tension élevée, le condensateur de détection comprenant
i) une électrode haute tension (160), connectée électriquement à l'élément de connexion (80) lorsque le bouchon d'isolation à capteur (1, 2, 3) est inséré dans la cavité arrière (70) du connecteur séparable (10) ;
ii) une électrode de détection (170), incorporée dans le premier matériau isolant (610),
iii) un diélectrique agencé entre l'électrode haute tension (160) et l'électrode de détection (170) et comprenant une partie (180) du premier matériau isolant (610),
c) une carte de circuit (200, 202, 204, 206, 208) comprenant un contact de signal (360), connecté de manière électroconductrice à l'électrode de détection (170),
**caractérisé en ce qu'**il comprend en outre
d) un capteur de température (500, 502), agencé sur la carte de circuit et comprenant une sonde de capteur (510), opérationnelle pour détecter une température à proximité de la sonde de capteur (510), en contact de surface avec le premier matériau isolant (610), ou accouplé thermiquement à celui-ci, pour détecter une température du premier matériau isolant (610).

2. Bouchon d'isolation à capteur (1, 2) selon la revendication 1, dans lequel la carte de circuit (200, 202, 204, 206) est incorporée dans le premier matériau isolant (610).

3. Bouchon d'isolation à capteur (3) selon la revendication 1, dans lequel la carte de circuit (208) est agencée dans un évidement (620) qui est formé dans le corps de bouchon (140) et rempli au moins partiellement avec un second matériau isolant électriquement (611), dans lequel la carte de circuit est incorporée dans le second matériau isolant (611).

4. Bouchon d'isolation à capteur (1, 2) selon l'une quelconque des revendications précédentes, dans lequel la sonde de capteur (510) est incorporée dans le premier matériau isolant (610).

5. Bouchon d'isolation à capteur (1, 2, 3) selon l'une quelconque des revendications précédentes, dans lequel le capteur de température (500, 502) comprend en outre un corps de capteur (520), dans lequel le corps de capteur (520) est agencé sur la carte de circuit (200, 202, 204, 206, 208).

6. Bouchon d'isolation à capteur (1) selon la revendication 5, dans lequel la sonde de capteur (510) est agencée à une distance du corps de capteur (520).

7. Bouchon d'isolation à capteur (1) selon l'une quelconque des revendications précédentes, dans lequel la sonde de capteur (510) est agencée entre l'électrode haute tension (160) et l'électrode de détection (170).

8. Bouchon d'isolation à capteur (1, 2, 3) selon l'une quelconque des revendications précédentes, comprenant en outre un fil de sortie de température (570), connecté électriquement au capteur de température (500, 502) et se terminant à l'extérieur du corps de bouchon (140), opérationnel pour transmettre électriquement une valeur de température détectée par le capteur de température (500, 502) à un extérieur du corps de bouchon (140).

9. Bouchon d'isolation à capteur (1, 2, 3) selon l'une quelconque des revendications précédentes, comprenant en outre un capteur thermique destiné à détecter une température de gaz ambiant à l'extérieur du bouchon d'isolation à capteur.

10. Bouchon d'isolation à capteur (1, 2, 3) selon l'une quelconque des revendications précédentes, dans lequel le capteur de température (500, 502) comprend une résistance électrique dépendant de la température, telle qu'une résistance PT100 ou une résistance comprenant du platine, du nickel, ou du cuivre, ou
dans lequel le capteur de température (500, 502) comprend une sonde de capteur à bande interdite en silicium, ou un thermocouple, ou un capteur de température numérique, ou dans lequel le capteur de température (500, 502) est un capteur de température à fibre optique comprenant une fibre optique.

11. Bouchon d'isolation à capteur (1, 2) selon l'une quelconque des revendications précédentes, comprenant en outre un matériau hautement conducteur thermiquement, tel que de l'or, de l'argent, du cuivre, de l'aluminium ou des alliages de ceux-ci, agencé entre, et en contact de surface avec, la sonde de capteur (510) et une partie du premier matériau isolant (610) pour améliorer un couplage thermique entre la partie du premier matériau isolant (610) et la sonde de capteur (510), dans lequel un matériau hautement conducteur thermiquement est un matériau qui a une conductivité thermique de 10 W/(m * K) ou plus à température ambiante.

12. Bouchon d'isolation à capteur (2, 3) selon la revendication 5, dans lequel la sonde de capteur (510) est agencée sur le corps de capteur (520), ou est agencée de manière à être en contact de surface avec le corps de capteur (520).

13. Connecteur séparable (10) moyenne tension ou haute tension, pouvant être monté sur une extrémité d'un câble de puissance (20) et comprenant une cavité arrière (70) et un élément de connexion (80) à tension élevée, pouvant être connecté électriquement au câble de puissance (20) et accessible à travers la cavité arrière (70) ;
dans lequel le connecteur séparable (10) comprend un bouchon d'isolation à capteur (1, 2, 3) selon l'une quelconque des revendications précédentes, inséré dans la cavité arrière (70), dans lequel l'électrode haute tension (160) est connectée électriquement à l'élément de connexion (80).

14. Réseau de distribution d'énergie destiné à distribuer de l'énergie électrique à moyennes ou hautes tensions, le réseau comprenant
a) un câble de puissance (20) destiné à conduire de l'énergie électrique dans le réseau de distribution de puissance à une tension élevée,
b) un connecteur séparable (10) moyenne tension ou haute tension, monté sur une extrémité du câble de puissance (20) et ayant une cavité arrière (70) et un élément de connexion (80) à tension élevée, connecté électriquement au câble de puissance (20) et accessible à travers la cavité arrière (70) ; et
c) un bouchon d'isolation à capteur (1, 2, 3) selon l'une quelconque des revendications 1 à 12, inséré dans la cavité arrière (70), dans lequel l'électrode haute tension (160) est connectée électriquement à l'élément de connexion (80).

15. Procédé d'installation d'un bouchon d'isolation à capteur (1, 2, 3) selon la revendication 8, comprenant la connexion électrique du fil de sortie de température (570) à un dispositif de traitement, tel qu'à un RTU, ou à un dispositif de détection.
